(19) Europäisches Patentamt
European Patent Office
Office européen des brevets

(11) Publication number: **0 171 605 B1**

(12) **EUROPEAN PATENT SPECIFICATION**

(45) Date of publication of patent specification: **14.02.90**

(51) Int. Cl.$^5$: **H 01 L 21/31,** C 23 C 16/04

(21) Application number: **85108627.2**

(22) Date of filing: **11.07.85**

(54) **Method of forming an insulating film on a semiconductor body.**

(30) Priority: **11.07.84 JP 142438/84
13.07.84 JP 144300/84**

(43) Date of publication of application:
**19.02.86 Bulletin 86/08**

(45) Publication of the grant of the patent:
**14.02.90 Bulletin 90/07**

(84) Designated Contracting States:
**CH DE FR GB IT LI NL SE**

(56) References cited:
**EP-A-0 054 189**
**EXTENDED ABSTRACTS, vol. 84, no. 1, May 1984, pages 251-252, Pennington, US; J.Y. CHEN et al.: "Photo-CVD for VLSI isolation"**
**JOURNAL OF THE ELECTROCHEMICAL SOCIETY, vol. 128, no. 4, April 1981, pages 918-919, Manchester, US; T. SERIKAWA et al.: "Lift-off patterning of sputtered SiO2 films"**
**IBM TECHNICAL DISCLOSURE BULLETIN, vol. 26, no. 4, September 1983, pages 1978-1979, New York, US; P. GELDERMANS et al.: "Method for making tapered via holes in polyimide films by plasma ashing"**

(73) Proprietor: **HITACHI, LTD.
6, Kanda Surugadai 4-chome Chiyoda-ku
Tokyo (JP)**

(72) Inventor: **Mochizuki, Yasuhiro
3-17-2-302, Moriyama-cho
Hitachi-shi Ibaraki-ken (JP)**
Inventor: **Tsukuda, Kiyoshi
2-37-3, Moriyama-cho
Hitachi-shi Ibaraki-ken (JP)**
Inventor: **Momma, Naohiro
1-2113, Ishinazaka-cho
Hitachi-shi Ibaraki-ken (JP)**
Inventor: **Hirao, Mitsuru
1737-169, Hyakutsukahara Shirakata Toukai-mura
Naka-gun Ibaraki-ken (JP)**

(74) Representative: **Patentanwälte Beetz sen. - Beetz jun. Timpe - Siegfried - Schmitt-Fumian
Steinsdorfstrasse 10
D-8000 München 22 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 171 605 B1

**Description**

Background of the Invention

The present invention relates to a method of forming an insulating film on a semiconductor body, and more particularly to a method of forming an insulating film on only selected areas of the surface of a semiconductor substrate or a method of forming a flat insulating film on the rugged surface of a semiconductor body.

In forming an insulating film, it has heretofore been often desired to form said film in only the areas of a predetermined pattern on the surface of a body. As one of methods therefor, the "lift-off method" has been known.

A described in the Official Gazette of JP—A—57—2545, the lift-off method is a method wherein those areas of the surface of a body which need not be formed with an insulating film are formed with the pattern of photoresist beforehand, said film in subsequently deposited on the whole surface of the resulting body, and the photoresist and said film overlying it are thereafter removed together.

With this method, in order to well define the area requiring said film and the area not requiring it at the edge of the pattern of the photoresist, various restrictions are imposed on the depositing conditions of said film and such forming conditions as the film thickness of the photoresist and the taper angle of the pattern edge.

This had led to the disadvantage that the precision of the pattern and the taper shape of the pattern end of said film are problematic, especially that the selective deposition of said film into a microminiature recess pattern in the surface of the body is difficult.

"Extended Abstracts", Vol. 84, No. 1, May 1984, pages 251 to 252, Chen et al. "Photo CVD for VLSI isolation" discloses a low temperature photochemical vapor deposition process for depositing a silicon dioxide film, using $SiH_4$ gas and $N_2O$ gas, on a substrate masked with a photoresist. The photoresist covered by silicon dioxide is thereafter removed by liftoff, leaving said substrate selectively covered with said silicone dioxide film which may serve to provide isolation among IC devices.

Summary of the Invention

An object of the present invention is to provide a method of forming an insulating film on a semiconductor body in which a patterned thin film is selectively formed on the surface of said body.

Another object of the present invention is to provide a method of forming an insulating film on a semiconductor body in which a patterned thin film is selectively deposited on the rugged surface of said body, whereby the surface of the body can be levelled.

The present invention provides a method of forming an insulating film on a semiconductor body wherein an organic substance film is provided on selected areas of one major surface of a semiconductor body, the semiconductor body with the organic substance film is accommodated in a reactor, and reactive gases containing oxygen for an insulating film to be formed on said semiconductor body are caused to flow into said reactor, to form said insulating film in accordance with chemical vapor deposition utilizing a photochemical reaction and oxidation and to simultaneously decompose said organic substance film owing to a photochemical reaction via oxidation, the feed rate of oxygen being adjusted in relation to the feed rates of the remaining reactive gases thereby to deposit said insulating film selectively on areas other than the areas where said organic substance film is provided.

The decomposition of the organic substance film, which can be a photoresist based on the photochemical reaction is interpreted as follows:

(a) When oxygen gas is irradiated with vacuum ultraviolet light having wavelengths not longer than 200 nm, ozone develops.

$$\begin{cases} O_2 \xrightarrow{hv} O + O \\ O_2 + O \rightarrow O_3 \end{cases}$$

(b) When the ozone is irradiated with ultraviolet light having wavelengths of 240—270 nm, an excited oxygen atom develops.

$$O_3 \xrightarrow{hv} O_2 + O^*$$

(c) The ozone as well as the excited oxygen atom has a very intense oxidizing power, and decomposes organic substances such as the photoresist. Decomposition products at that time scatter as gases.

$$O_3 \text{ or } O^* + C_wH_xO_yN_z \rightarrow CO, CO_2, H_2O, NO, NO_2, N_2O$$

On the other hand, the formation of the thin film based on the similar photochemical reaction is interpreted as follows:

(a) A silicon oxide film is formed from the oxygen mentioned above and the reactive gas of silicon for example, silane.

$$O + SiH_4 \rightarrow SiO_2 + H_2$$

(b) With the mercury sensitization method which adds mercury vapor into reactive gases and which employs the resonant line of a mercury-vapor lamp as an ultraviolet light source, various gases can be reacted.

$$SiH_4 + O_2 \xrightarrow[Hg]{hv} SiO_2$$

$$Si(OR)_4 + O_2 \xrightarrow[Hg]{hv} SiO_2$$

$$SiH_4 + N_2O \xrightarrow[Hg]{hv} SiO_2$$

$$SiH_4 + NH_3 \xrightarrow[Hg]{hv} Si_3H_4$$

$$SiH_4 \xrightarrow[Hg]{hv} Si$$

where R: alkyl group or the like

The present invention consists in that the rates of the various reactions are properly controlled, whereby:

(1) the photoresist is decomposed by the photochemical reaction, so the formation of the thin film thereon is prevented from taking place,

(2) while at the same time the thin film is deposited on only the exposed parts of the body similarly by the photochemical reaction.

Brief Descripton of the Drawings

Fig. 1 is a view showing a photochemical reaction apparatus which was used in the performance of the present invention:

Figs. 2(a)—2(e) are schematic sectional views of the respective steps of an example in which a silicon integrated circuit device was manufactured by applying the present invention.

Figs. 3(a)—3(e) are schematic sectional views of the respective steps of an example in which an inter-layer insulator film for a multilayer wiring structure was formed in a silicon integrated circuit device by applying the present invention;

Figs. 4(a)—4(g) are schematic sectional views of the respective steps of an example in which, as in the example shown in Figs. (3(a)—3(e), inter-layer insulation for a multilayer wiring structure was done in a silicon integrated circuit device in accordance with the present invention; and

Figs. 5(a)—5(i) are schematic sectional views of the respective steps of another example in which inter-layer insulation for a multilayer wiring structure was done in a silicon integrated circuit in accordance with the present invention.

Concrete Description on Embodiments

Fig. 1 shows a photochemical reaction apparatus which was used in the performance of the present invention. When broadly divided, the apparatus is constructed of the three systems of a reactive gas supply system 10, a reactive system 20 and an evacuation system 30.

In the reactive gas supply system 10, reactive gases such as monosilane ($SiH_4$), oxygen ($O_2$), alkoxysilane, e.g. tetraethoxysilane ($(C_2H_5O)_4Si$) and phosphine ($PH_3$) are passed through mass flow controllers 11a—11d so as to be supplied to the reaction system 20.

The monosilane ($SiH_4$) and the tetraethoxysilane ($(C_2H_5O)_4Si$) serve as the raw materials of silicon (Si), and either of them is used. Even when the tetraethoxysilane is replaced with another alkoxysilane, for example, ethyl triethoxysilane [$(C_2H_5O)_3Si(C_2H_5$], vinyl triethoxysilane [$(C_2H_5O)_3SiCH{=}CH_2$], phenyl triethoxysilane [$(C_2H_5O)_3Si(C_6H_5)$] or dimethyl diethoxysilane [$(C_2H_5O)_2Si(CH_3)_2$], the selective film of the thin film can be similarly formed.

The phosphine ($PH_3$) is employed in a case where n-type silicon is to be selectively formed as the thin film or where phosphosilicate glass, namely glass made from $SiO_2$ and $P_2O_5$ is to be formed. As other materials, it is possible to use gases such as arsine ($AsH_3$), arsenic pentafluoride ($AsF_5$), phosphorus trifluoride ($PF_3$) and phosphorus pentafluoride ($PF_5$) or liquid dopants such as phosphorus trichloride ($PCl_3$) and phosphorus oxychloride ($POCl_3$).

In a case where silicon is to be endowed with p-type conductivity, the phosphine ($PH_3$) can be replaced with a gas such as diborane ($B_2H_6$), boron trichloride ($BCl_3$) or boron trifluoride ($BF_3$) or liquid dopant such as boron tribromide ($BBr_3$).

Mercury vapor as a sensitizer is fed into the reaction system 20 by causing the reactive gas or any other carrier gas to flow through a mercury vaporizer 12 within a constant-temperature oven (not shown in the figure).

The reaction system 20 is composed of a reaction vessel 21, an ultraviolet light source 22, a substrate stage 23, and a heating source 24 for the substrate stage. The reaction vessel 21 is provided with a light window (not shown) made of synthetic quartz which has a high transmission factor for vacuum ultraviolet light.

Substrates to be formed with films, for example, silicon wafers 25 formed with photoresist patterns are placed on the plane of the aluminum-made substrate stage 23 within the reaction vessel 21, and the wafers 25 are substantially perpendicularly irradiated with the ultraviolet excitation light from the ultraviolet light source 22.

As the heating source 24, a resistance heater or an infrared-ray lamp can be employed.

In order to substitute gases in the reaction vessel 21 and to regulate atmospheric pressures during reactions, the evacuation system 30 has a rotary pump, and a vacuum pump 31 of a booster pump. Here, a trap 32 for unreacted gases and reaction products is additionally provided between the reaction vessel 21 and the vacuum pump 31.

Example 1

A pattern of photoresist was formed on the front surface of a silicon single-crystal water or substrate. The photoresist was a negative type resist based on synthetic rubber, and was 600 nm thick.

The photoresist pattern was formed by coating → pre-baking → exposure to light → developing → rinse → post-baking as in a conventional photoresist process.

The resulting substrate was placed on the substrate stage 23 within the reaction vessel 21 in

Fig. 1, and was heated to 160°C. In this case, when the heating temperature is too high, the photoresist is softened and deformed to worsen the pattern accuracy. Therefore, the temperature setting needs to be controlled so as to prevent overshooting.

Next, reactive gases were supplied into the reaction vessel 21 to excite photochemical reactions and to form a thin film on the surface of the substrate.

As the reactive gases therefor, monosilane (concentration: 20%, base gas: nitrogen) at 250 ml/min (50 ml/min as monosilane), oxygen at 600 ml/min and nitrogen at 2000 ml/min were caused to flow in. The monosilane and the nitrogen were passed via the mercury vaporizer (12 in Fig. 1) held at 35°C, and were used as carriers for mercury vapor.

The internal pressure of the reaction vessel 21 at this time was 20 KPa (0.2 atmosphere (150 Torr)). The ultraviolet light source 22 used was a low-pressure mercury-vapor lamp made of a synthetic quartz tube, which projected ultraviolet rays at a wavelength of 254 nm (the intensity of which at the substrate surface was higher than 40 mW/cm$^2$) and at a wavelength of 185 nm (the intensity of which was about 15% of that of the wavelength of 254 nm).

Points important here are the concentrations of the reactive gases, especially the ratio between the feed rates of the monosilane and the oxygen and the partial pressure of the oxygen.

In case of holding the feed rate of the monosilane constant and increasing that of the oxygen, the deposition rate of the silicon oxide film increases rapidly until the ratio between the feed rates of the monosilane and the oxygen reaches 1:1, and it becomes nearly constant when the ratio is 1:2 or greater.

However, when the feed rate of the oxygen is low, the silicon oxide film is deposited also on the photoresist, and the situation becomes similar to that in the conventional "lift-off" without realizing the selective deposition. The reason is that the quantities of generation of ozones and excited oxygen atoms are insufficient.

When the feed rate of the oxygen gas is raised, the quantities of the ozone and the excited oxygen atoms become sufficiently large, and the decomposition of the photoresist proceeds rapidly, so that the deposition of the silicon oxide film on the photoresist can be prevented.

The inventors' experiments has revealed that, in order to ensure the selective deposition of the silicon oxide film, the feed rate of the oxygen gas needs to be at least 8 times as high as that of the monosilane.

The ratio between the feed rates of the oxygen and the monosilane, which is required for the selective deposition of the silicon oxide film based on the decomposition of the photoresist, does not depend upon the pressure of the reactive gases.

However, when the pressures of the reactive gases are excessively high, a stepped part is not sufficiently filled with the silicon oxide film, so that the pattern accuracy worsens.

Under the conditions mentioned above, the deposition rate of the silicon oxide film was 50 nm/min, and the decomposition rate of the photoresist was 30—40 nm/min. With the reactions for 12 minutes, therefore, the thickness of the silicon oxide film formed on the surface of the silicon single-crystal wafer or substrate reached 600 nm, while the thickness of the photoresist decreased by 360—480 nm and became 120—240 nm.

Using a similar substrate, a silicon oxy nitride film was formed by supplying monosilane (concentration: 20%, base gas: nitrogen) at 250 ml/min and ammonia at 1000 ml/min through the mercury vaporizer as reactive gases.

Oxygen at 600 ml/min was added in the reactive gases because the decomposition of photoresist was necessary for selectively forming the film without depositing it on the photoresist. As a result, the silicon oxynitride film ($SiO_xN_y$) was deposited selectively on only the surface of the substrate.

When the composition of the deposited film thus obtained was subjected to a half quantitative analysis with an X-ray microanalyzer, the ratio [O]/[N] between the contents of oxygen and nitrogen was about 25.

It has been experimentally confirmed that the aforementioned composition ratio is more dependent upon reaction temperatures than upon the feed rates of the raw material gases and that the nitrogen content increases more at a higher temperature.

Next, the atmosphere of the interior of the reaction vessel 21 was set to an oxygen current of 100 KPa (1 atm.), and the substrate temperature was set at 400°C, whereby all the photoresist left behind was decomposed and removed at a rate of at least 100 nm/min. Such raising of the substrate temperature serves also the densification of the deposited silicon oxide or silicon nitride film.

In the above way, the silicon oxide or silicon oxynitride film can be formed in only the selected areas of a predetermined pattern on the substrate.

Example 2

An example in which the present invention was applied to the isolation technique of a silicon integrated circuit device, will be described with reference to Figs. 2(a)—2(e).

Fig. 2(a) shows a substrate in which the front surface of a silicon single-crystal wafer 51 was formed with a silicon oxide film 52 having a thickness of 100 nm by thermal oxidation.

Fig. 2(b) shows a state in which a pattern of photoresist 53 was formed on the substrate. The photoresist 53 was the same as in Example 1, and the pattern was such that an isolation region was open.

In the illustrated state of Fig. 2(c), the silicon oxide film 52 was etched by plasma etching which employed the photoresist 53 as a mask and which used a gaseous mixture consisting of Freon-14

($CF_4$) and oxygen, whereupon a recess 54 having a depth of 900 nm was formed in the surface of the silicon single-crystal wafer 31.

In the illustrated state of Fig. 2(d), a silicon oxide film 55 functioning as an isolation layer was selectively deposited and packed in the recess 54 of the silicon single-crystal wafer 51 by photochemical reactions.

Tetraethoxysilane ($(C_2H_5O)_4Si$) was used as a raw material gas in this case, and the silicon oxide film 55 was formed by the mercury sensitization method.

The silicon oxide film formed using the tetraethoxysilane is lower in density when compared with that formed using the monosilane in Example 1. On the other hand, however, it has the merit that the dependence on the feed rate of the oxygen gas during the reaction is less.

This brings forth the advantage that the feed rate of the oxygen gas in the case of using the tetraethoxysilane can be set with note taken only of conditions for decomposing the photoresist. The denseness of the deposited film can be improved by a subsequent annealing step.

In this example, the substrate temperature was held at 160°C, and the tetraethoxysilane and the oxygen gas at 40 ml/min as a carrier gas for mercury were supplied. The reaction pressure on this occasion was 1,3—2.0 KPa (10—15 Torr).

By the reactions for 80 minutes, the recess 54 of the silicon single-crystal wafer 51 not covered with the photoresist could be filled up with the silicon oxide film 55 having a thickness of 1000 nm. At this time, the photoresist 53 was decomposed and removed by about 300 nm.

The mechanism of the deposition of the silicon oxide film based on the photochemical reactions and employing the tetraethoxysilane as the main reactive gas is unclear. As the result of the inventors' experiment, however, it has been found that in order to give rise to the deposition, the following three conditions are required:

(1) to supply oxygen gas to a reactive gas,

(2) to supply mercury vapor into reactive gases as a sensitizer, and

(3) to project a excitation light, not only the ultraviolet ray of a low-pressure mercury-vapor lamp at a wavelength of 253.7 nm, but also the ultraviolet ray at a wavelength of 184.9 nm, and that no silicon oxide film is deposited when any of the requirements is wanting.

Fig. 2(e) shows a state in which the photoresist 53 remaining in the state of Fig. 2(d) was fully decomposed and removed, whereupon the resulting substrate was annealed. The decomposition at the photoresist was carried out in an oxygen current atmosphere of 100 KPa (1 atm).

After the removal of the photoresist, the silicon single-crystal wafer 51 was taken out of the reaction vessel 21 (Fig. 1) and was heat-treated at 900°C for 10 minutes. Thus, the deposited silicon oxide film 55 was densified, and it fused with the thermal oxide film 52 previously formed on the surface of the silicon single-crystal wafer 51, whereby the surface was levelled.

Example 3

An example of the present invention applied to an inter-layer insulator film for the multilayer wiring structure of a silicon integrated circuit will be described with reference to Figs. 3(a)—3(e).

Figs. 3(a) shows a state after a silicon semiconductor substrate 61 was formed with a wiring pattern 62 of aluminum-silicon alloy (thickness: 800 nm) by photoetching and before photoresist 63 was removed.

In the illustrated state of Fig. 3(b), the substrate 61 was set in the reaction vessel 21 (in Fig. 1), and a silicon oxide film 64 was first deposited to a thickness substantially equal to or somewhat greater than the thickness of the wiring layer 62 by the selective thin-film forming method of the present invention employing tetraethoxysilane and oxygen.

Reaction conditions were the same as in Example 2 except that the reaction period of time was 70 minutes.

In the illustrated state of Fig. 3(c), the substrate 61 was heated to 400°C to decompose and remove the remaining photoresist in an oxygen current and to densify the deposited film 64.

As the result of the heat treatment, the wiring layer 62 and the silicon oxide film 64 became of substantially equal thicknesses, and their surfaces were levelled.

In the illustrated state of Fig. 3(d), a silicon oxide film 65 containing phosphorus at a concentration of 6 mole% (phosphosilicate glass film on PSG film) was further deposited on the whole surfaces of the wiring layer 62 and the silicon oxide film 64 on the body to a thickness of 650 nm by the ordinary chemical vapor deposition (CVD) which employed monosilane, phosphine and oxygen gas.

In the illustrated state of Fig. 3(e), the silicon oxide film 65 on the substrate was formed with a through hole 66 as in the prior-art process, whereupon the pattern of a second layer of wiring layer 67 was formed.

Since, according to the method of the present example, the inter-layer insulator film can be formed flat, the disconnection of the wiring layers at the stepped part can be prevented and the pattern controllability of the photoetching can be enhanced. Therefore, enhancement in the available percentage to cope with microminiaturization and higher density of integration can be expected.

In addition, this example has the advantage that the steps of Figs. 3(b)—3(d) can be performed continuously without taking the substrate 61 out of the reaction vessel 21, merely by selecting and changing the gases to be introduced into the reaction vessel.

Although the selective deposition of the silicon oxide film has been explained in Examples 1 and 2 of the present invention, oxides of different materials, for example, aluminum, tantalum, indium, titanium, etc., can also be formed by altering the raw material gas.

In Example 3 which is an example of application

to the inter-layer insulator film for the multilayer wiring, the recess of the wiring layer was filled up with the silicon oxide film, and the PSC film was thereafter deposited on the whole area by the CVD process. However, a film of another material such as silicon nitride film can also be deposited by a different method of formation.

Example 4

Levelling based on the formation of the selective film of an inter-layer insulator film for the multilayer wiring structure of a silicon integrated circuit will be described in detail with reference to Figs. 4(a)—4(g).

Fig. 4(a) shows a state in which an aluminum-silicon (98% Al — 2% Si) alloy layer 72 to serve as a first layer of wiring layer was formed on a silicon semiconductor body 71 having completed junction forming and surface treating steps, to a thickness of 0.8 µm by sputtering.

Fig. 4(b) shows a state after the aluminum-silicon alloy layer 72 was formed into a predetermined pattern 73 by photoetching and before photoresist 74 was removed. More specifically, after the body was subjected to the various steps of:

coating with the photoresist 74 (synthetic rubber-based negative type photoresist) → pre-baking → exposure to light → developing → rinse → post-baking as in a conventional photoetching process, the wiring layer or alloy layer 72 was etched with a phosphoric acid-based etchant ($H_3PO_4$ 77% + $CH_3COOH$ 15% + $HNO_3$ 3% + $H_2O$ 5%).

In the illustrated state of Fig. 4(c), an insulator film 75 was selectively deposited on the resulting substrate by photo-CVD. In order to perform the photo-CVD, the substrate 71 was set as the substrate 25 on the substrate stage 23 within the reaction vessel 21 shown in Fig. 1, and it was heated to 155°C.

In this case, when the heating temperature is too high, the photoresist 74 is softened and deformed to worsen the pattern accuracy. Therefore, the temperature setting needs to be controlled so as to prevent overshooting.

Next, reactive gases were supplied into the reaction vessel 21 to excite the photochemical reactions and to form the thin film. As stated before, reaction conditions require the matching between the decomposition of the photoresist and the selective film deposition on the surface of the substrate. The reactive conditions will now be described in detail.

(1) In forming a silicon oxide film on the basis of a photochemical reaction which employs monosilane as a reactive as for a principal raw material, it is important to control the ratio between the feed rates of the monosilane and oxygen and the partial pressure of the oxygen.

In a case where the feed rate of the oxygen gas is low, the decomposition of photoresist becomes insufficient, and the silicon oxide film deposits also on the photoresist, so that a selective film is not formed.

In order to facilitate the decomposition of the photoresist, the feed rate of the oxygen gas needs to be increased. For the selective formation of the silicon oxide film, the ratio between the feed rate of the oxygen gas and that of the monosilane is important and should desirably be at least 8 times, but the formation does not depend upon the pressure of the reactive gases. However, when the pressures of the reactive gases are high, a stepped part is poorly filled up, and the pattern accuracy degrades. In a pattern having a wiring width of 2 µm and wiring intervals of 2 µm, the pressures of the reactive gases should properly be at most 2.7 KPa (20 Torr).

(2) In forming a silicon oxide film on the basis of photochemical reactions which employ alkoxysilane as a principal reactive gas, the deposition rate is low, but the selectivity of film deposition is favorable.

Here in this example, the silicon oxide film 75 was deposited to a thickness somewhat greater than the thickness of the first layer of wiring layer or pattern 73 in accordance with the second method, namely, with the photochemical reactions which used oxygen and tetraethoxysilane ($Si(OC_2H_5)_4$) being a kind of alkoxysilane.

As reaction conditions in this case, the tetraethoxysilane and oxygen gas at 40 ml/min as a carrier gas for mercury were supplied, and the reaction pressure was set at 1.3 KPa (10 Torr). By the reactions for 80 minutes, the silicon oxide film 75 having a thickness of 900 nm could be deposited in an area not covered with the photoresist 74. At this time, the photoresist 74 was decomposed and removed by about 300 nm.

Fig. 4(d) shows a state in which the resultant body 71 was heated to 400°C in the identical reaction vessel without being taken out, to decompose and remove the remaining photoresist 74 in an oxygen current and to densify the deposited film 75.

As a result, the first layer of wiring layer 73 and the silicon oxide film 75 became of substantially equal thicknesses, and their surfaces were levelled.

In the illustrated state of Fig. 4(e), an electrically-conductive connecting column 76 was formed by photoetching between the first layer of wiring layer 73 already formed and a second layer of wiring layer to be subsequently formed.

In order to form the connecting column 76, a molybdenum layer 0.03 µm thick and an aluminum-silicon alloy layer 0.5 µm thick were successively deposited on the whole areas of the wiring layer pattern 73 and the silicon oxide film 75 overlying the substrate 71 in Fig. 4(d), and the pattern of photoresist 77 was formed. Thereafter, the resulting substrate was subjected to reactive ion etching by the use of a gaseous mixture consisting of carbon tetrachloride ($CCl_4$) and chlorine ($Cl_2$).

The conditions of the etching were a gas pressure of 10.6 Pa (0.08 Torr), and RF power of 200 W and an RF frequency of 3 MHz. Since molybdenum has its etching rate selected at a

great ratio with respect to the silicon oxide film, it can clearly define the end point of the etching advantageously.

Fig. 4(f) shows a state in which an inter-layer insulator film 78 was formed on the surface portion except the connecting column 76 by the selective deposition of the silicon oxide film 78 as at the steps of Figs. 4(c) and 4(d).

Phosphine was mixed in the raw material gases during the photochemical reactions, thereby to form the silicon oxide film doped with about 4% of phosphorus. This utilized the known gettering effect of a phosphorus-doped silicon oxide film and the enhancement of a dielectric breakdown voltage.

Of course, it is to be understood that the mere silicon oxide film not doped with phosphorus is feasible as the inter-layer insulator film.

In the illustrated state of Fig. 4(g), the pattern of a second layer of wiring layer 79 was formed on the surfaces of the connecting column 76 and the inter-layer insulator film 78. A method of forming the wiring layer 79 can conform to the deposition of an aluminum-silicon alloy layer and the photoetching process likewise to that of the pattern of the first layer of wiring layer 73.

Further, it is obvious that, not only the wiring structure of the two layers, but also a multilayer wiring structure of more layers can be formed flat by successively repeating the above steps.

As described above in detail, according to the present invention, a multilayer wiring structure can be formed flat, and the prevention of the disconnection of wiring at a stepped part and the enhancement of the pattern accuracy of photoetching can be achieved. Therefore, the enhancement of available percentage and the enhancement of reliability to cope with the microminiaturization and raised density of integration can be expected.

By making the material of an inter-layer connecting column different from that of a wiring layer, it is possible to achieve the effect that an etching end point in the case of etching and forming the inter-layer connecting column can be judged readily and precisely.

Example 5

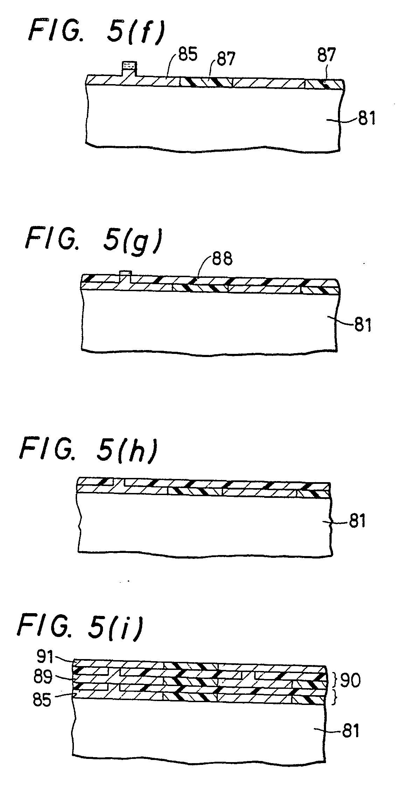

Next, another application to the multilayer wiring structure of a silicon semiconductor integrated circuit will be described in detail with reference to Figs. 5(a) — 5(i).

Fig. 5(a) shows a silicon semiconductor substrate 81 which completed junction forming and surface treating steps.

Fig. 5(b) shows a state in which an aluminum-silicon (98% Al—2% Si) alloy layer 82 to serve as a first layer of wiring layer and an inter-layer connector was formed on the body 81 to a thickness of 2.1 µm by sputtering.

Fig. 5(c) shows a state after the aluminum-silicon alloy layer was etched and removed from its surface by the thickness 1.3 µm of the inter-layer insulator film so as to form the inter-layer connector 83 and before photoresist 84 was removed. Likewise to an ordinary process, photoetching was carried out in conformity with coating with the photoresist → pre-baking → exposure to light → developing → rinse → post-baking so as to form the photoresist pattern 84, and the resultant substrate was thereafter subjected to reactive ion etching by the use of a gaseous mixture which consisted of carbon tetrachloride ($CCl_4$) and chlorine ($Cl_2$). The conditions of the etching were a gas pressure of 10.6 Pa (0.08 Torr), an RF power of 200 W and an RF frequency of 3 MHz.

Fig. 5(d) shows a state similar to the above, after the first layer of wiring layer 85 was formed by photoetching again and before photoresist 86 was removed.

In the illustrated state of Fig. 5(e), an insulator film 87 was selectively deposited on the substrate by photo-CVD. In performing the photo-CVD, the substrate 81 was set on the substrate stage 23 in the reaction vessel 21 in Fig. 1 and was heated to 155°C. When the temperature is too high, the photoresist 86 is softened and deformed to worsen the pattern accuracy. Therefore, the temperature setting needs to be controlled so as to prevent overshooting. Subsequently, reactive gases were supplied into the reaction vessel, and the substrate was irradiated with ultraviolet rays (wavelengths: 185 and 254 nm) from a low-pressure mercury-vapor lamp, thereby to excite photochemical reactions and to form the thin film. As stated before, reaction conditions require the matching between the photo-decomposition of the photoresist and the selective film deposition on the surface of the substrate. Here, tetraethoxysilane ($Si(OC_2H_5)_4$) and oxygen gas at 50 ml/min as a carrier gas for mercury were supplied, and the reaction pressure was 2.13 Kpa (16 Torr). By the reactions for 40 minutes, the silicon oxide film 87 having a thickness of 800 nm could be deposited only in an area not covered with the photoresist. At this time, the photoresist was decomposed and removed by a thickness of about 300 nm.

Fig. 5(f) shows a state in which the body 81 was held in the identical reaction vessel with its atmosphere being an oxygen current, to decomposed and remove the photoresist remaining on the pattern of the first layer of wiring layer.

In the illustrated state of Fig. 5(g), the body 81 held in the identical reaction vessel had an insulator film 88 selectively deposited thereon by photo-CVD again. A method of formation was similar to that in the case of Fig. 5(e).

Fig. 5(h) shows a state in which the photoresist on the inter-layer connector 83 was decomposed and removed as in Fig. 5(f). The steps of Figs. 5(e) —5(h) can be continuously performed within the identical reaction vessel, and the film deposition based on the photo-CVD fills the stepped part of the substrate surface favorably. As a result, the surface was completely levelled.

Fig. 5(i) shows a state in which a second layer of wiring layer and inter-layer connector 89, an inter-layer insulator film 90 and a third layer of wiring

layer 91 were formed by repeating the above steps in succession.

The process of the present invention and the simplest process in the prior art will be compared.

The formation of the simplest two-layer wiring structure in the prior art involves the six steps of:

(1) depositing a first conductive layer,

(2) forming a pattern of a first layer of wiring layer by photoetching the first conductive layer,

(3) depositing an inter-layer insulator film,

(4) forming a through hole by photoetching the inter-layer insulator film,

(5) depositing a second conductive layer, and

(6) forming a pattern of a second layer of wiring layer by photoetching the second conductive layer, and it consists of the three photoetching steps and the three film depositing steps.

On the other hand, according to one embodiment of the present invention the process involves the six steps of:

(1) depositing a first conductive layer,

(2) forming an inter-layer connector by photoetching the first conductive layer,

(3) forming a pattern of a first layer of wiring layer by photoetching the first conductive layer,

(4) selectively depositing an inter-layer insulator film and decomposing and removing photoresist by photo-CVD (continuously repeated within an identical reaction vessel),

(5) depositing a second conductive layer, and

(6) forming a pattern of a second layer of wiring layer by photoetching the second conductive layer, and it consists of the three photoetching steps and the three film depositing steps. It is accordingly understood that the same number of steps as in the simplest process in the prior art suffice.

## Claims

1. A method of forming an insulating film on a semiconductor body wherein an organic substance film is provided on selected areas of one major surface of a semiconductor body, the semiconductor body with the organic substance film is accommodated in a reactor, and reactive gases containing oxygen for an insulating film to be formed on said semiconductor body are caused to flow into said reactor, to form said insulating film in accordance with chemical vapor deposition utilizing a photochemical reaction and oxidation and to simultaneously decompose said organic substance film owing to a photochemical reaction via oxidation, the feed rate of oxygen being adjusted in relation to the feed rates of the remaining reactive gases thereby to deposit said insulating film selectively on areas other than the areas where said organic substance film is provided.

2. A method of forming an insulating film on a semiconductor body as defined in Claim 1, wherein the deposited film is a silicon oxide film, and oxygen and alkoxysilane are used as said reactive gases.

3. A method of forming an insulating film on a semiconductor body as defined in Claim 1, wherein the deposited film is one member selected from the group consisting of a silicon oxide film and a silicic nitride film; oxygen, ammonia and silane are used as said reactive gases; and the feed rate of the oxygen is at least 8 times higher than that of the silane.

4. A method of forming an insulating film on a semiconductor body as defined in Claim 1, wherein said organic substance film is made of photoresist.

## Patentansprüche

1. Verfahren zum Bilden einer Isolierschicht auf einem Halbleiterkörper, bei dem eine organische Stoffschicht auf ausgewählten Bereichen einer Hauptoberfläche eines Halbleiterkörpers vorgesehen wird, der Halbleiterkörper mit der organischen Stoffschicht in einem Reaktionsgefäß angebracht wird und Sauerstoff enthaltende reaktive Gase für eine auf dem Halbleiterkörper zu bildende Isolierschicht in das Reaktionsgefäß einströmen gelassen werden, um die Isolierschicht gemäß chemischer Dampfabscheidung unter Verwendung einer photochemischen Reaktion und Oxidation zu bilden und gleichzeitig die organische Stoffschicht aufgrund einer photochemischen Reaktion über Oxidation zu zersetzen, wobei der Durchsatz des Sauerstoffs in Beziehung zu den Durchsätzen der übrigen reaktiven Gase justiert wird, um dadurch die Isolierschicht selektiv auf anderen Bereichen als den Bereichen abzuscheiden, wo die organische Stoffschicht vorgesehen wird.

2. Verfahren zum Bilden einer Isolierschicht auf einem Halbleiterkörper nach Anspruch 1, wobei die abgeschiedene Schicht eine Siliziumoxidschicht ist und Sauerstoff und Alkoxysilan als die reaktiven Gase verwendet werden.

3. Verfahren zum Bilden einer Isolierschicht auf einem Halbleiterkörper nach Anspruch 1, wobei die abgeschiedene Schicht ein aus der Gruppe gewähltes Glied ist, die aus einer Siliziumoxidschicht und einer Siliziumnitridschicht besteht, Sauerstoff, Ammoniak und Silan als die reaktiven Gase verwendet werden und der Durchsatz des Sauerstoffs wenigstens achtmal höher als der des Silans ist.

4. Verfahren zum Bilden einer Isolierschicht auf einem Halbleiterkörper nach Anspruch 1, wobei die organische Stoffschicht aus Photoresist besteht.

## Revendications

1. Procédé pour former une pellicule isolante sur un corps semiconducteur, selon lequel on dispose une pellicule d'une substance organique sur des zones sélectionnées d'un surface principale d'un corps semiconducteur, on insère le corps semiconducteur portant la pellicule de substance organique à l'intérieur d'une enceinte réactionnelle, et on fait pénétrer dans ladite enceinte réactionnelle des gaz réactifs contenant

de l'oxygène pour une pellicule isolante devant être formée sur ledit corps semiconducteur, de manière à former ladite pellicule isolante au moyen d'un dépôt chimique en phase vapeur utilisant une réaction photochimique et une oxydation et décomposer simultanément ladite pellicule de substance organique sur la base d'une réaction photochmique, au moyen d'une oxydation, le débit d'amenée de l'oxygène étant réglé en rapport avec les débits d'amenée des autres gaz réactifs, de manière à obtenir le dépôt sélectif de ladite pellicule isolante sur des zones autres que les zones, dans lesquelles ladite pellicule de substance organique est disposée.

2. Procédé pour former une pellicule isolante sur un corps semiconducteur selon la revendication 1, selon lequel la pellicule déposée est une pellicule d'oxyde de silicium, et on utilise de l'oxygène et une alkoxysilane comme gas réactifs.

3. Procédé pour fabriquer une pellicule isolante sur un corps semiconducteur selon la revendication 1, selon lequel la pellicule déposée est un élément choisi dans le groupe incluant une pellicule d'oxyde de silicium et une pellicule de nitrure silicique; on utilise de l'oxygène, de l'ammoniac et du silane comme gaz réactifs; et le débit d'amenée de l'oxygène est au moins 8 fois supérieur à celui du silane.

4. Procédé pour fabriquer une pellicule isolante sur un corps semiconducteur selon la revendication 1, selon lequel ladite pellicule de substance organique est constituée par une résine photosensible.

FIG. 1

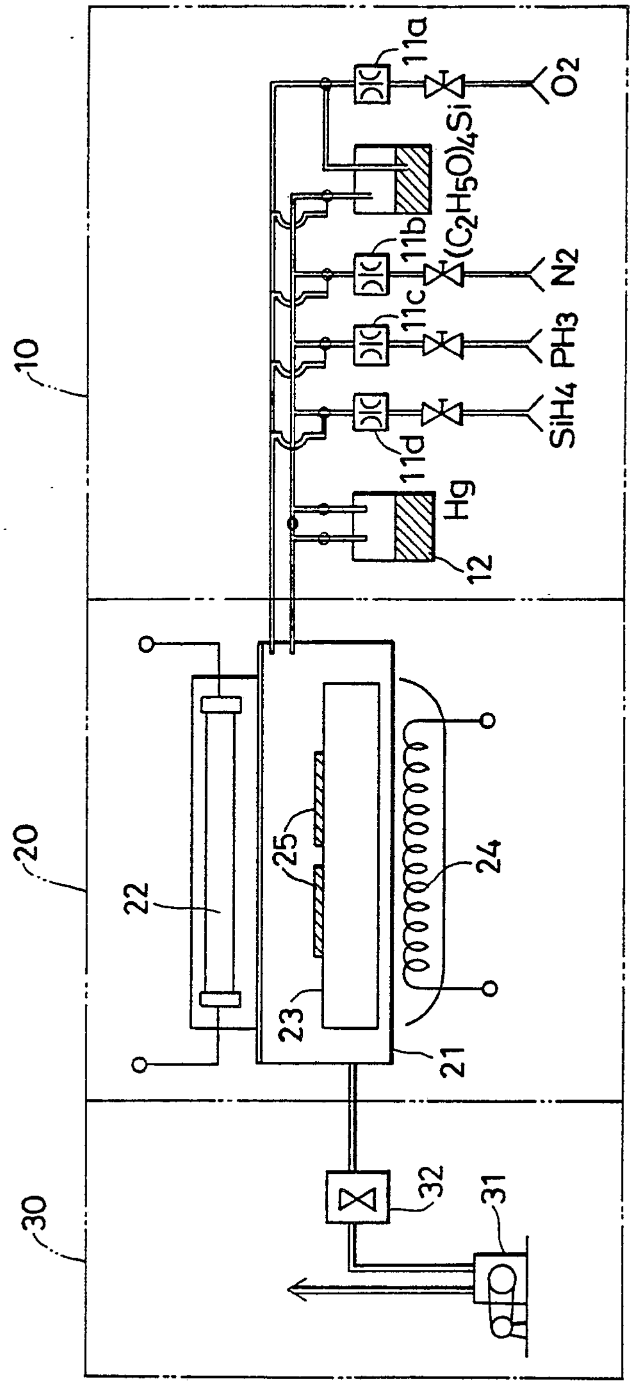
10
11a
$O_2$
$(C_2H_5O)_4Si$
11b
$N_2$
11c
$PH_3$
$SiH_4$
11d
Hg
12
20
22
25
24
23
21
30
32
31

FIG. 2(a)

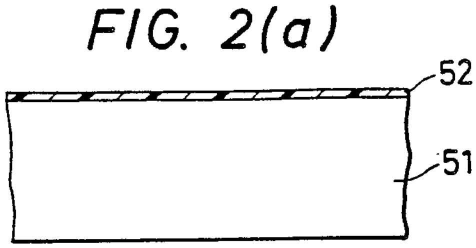


FIG. 2(b)

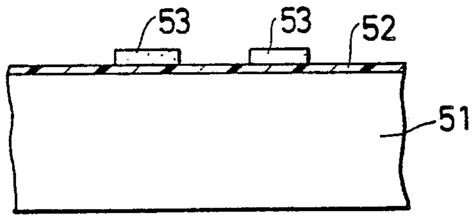


FIG. 2(c)

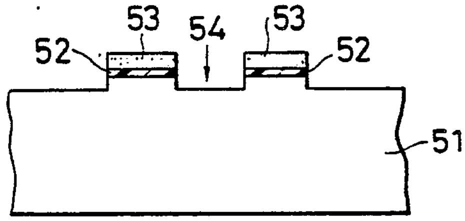


FIG. 2(d)

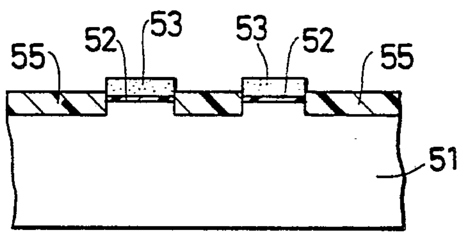


FIG. 2(e)

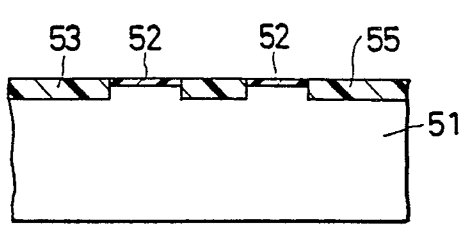


FIG. 3(a)

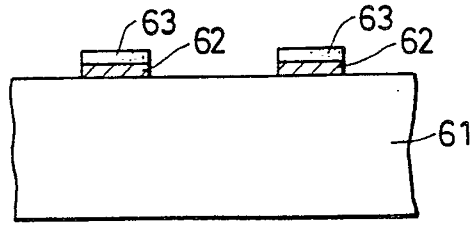


FIG. 3(b)

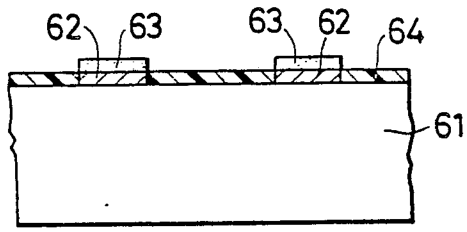


FIG. 3(c)

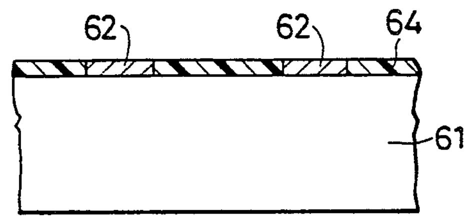


FIG. 3(d)

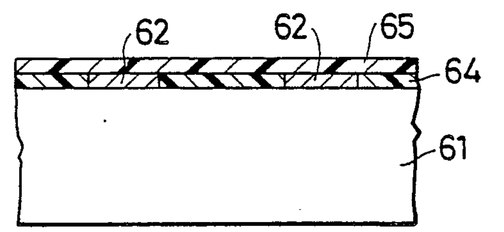


FIG. 3(e)

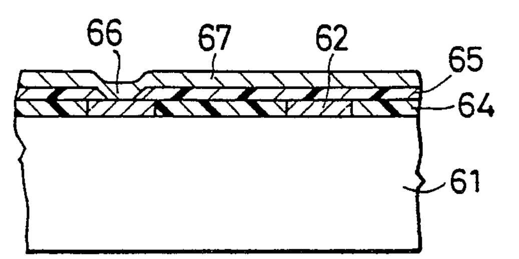

FIG. 4(a)

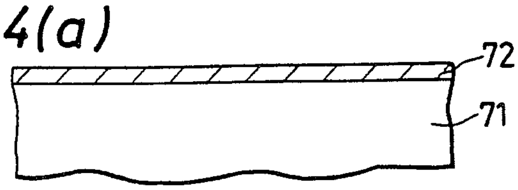


FIG. 4(b)

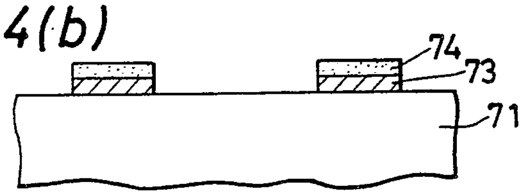


FIG. 4(c)

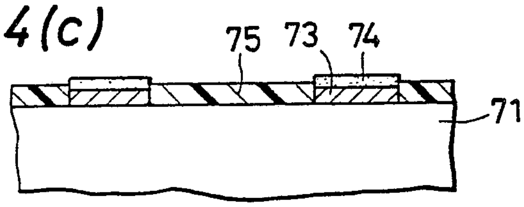


FIG. 4(d)

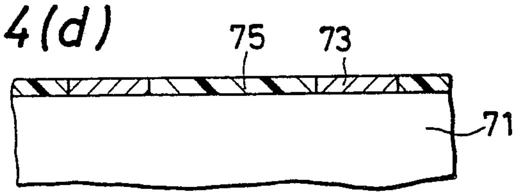


FIG. 4(e)

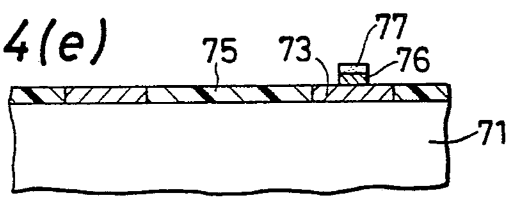


FIG. 4(f)

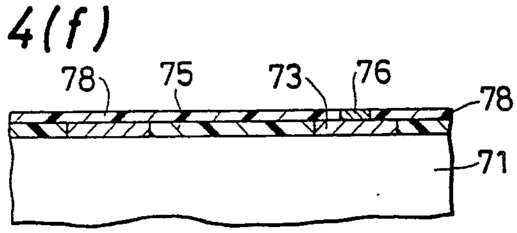


FIG. 4(g)

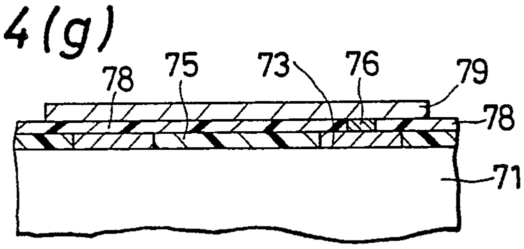

FIG. 5(a)

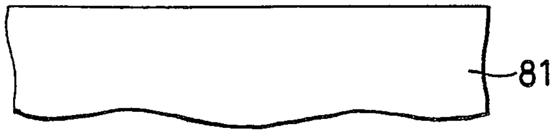


FIG. 5(b)

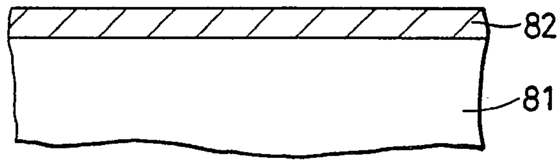


FIG. 5(c)

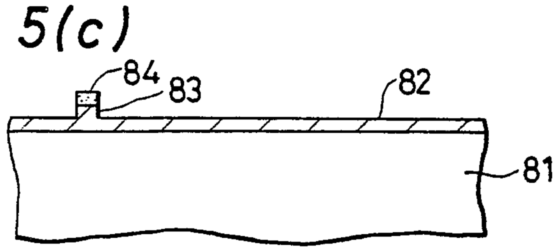


FIG. 5(d)

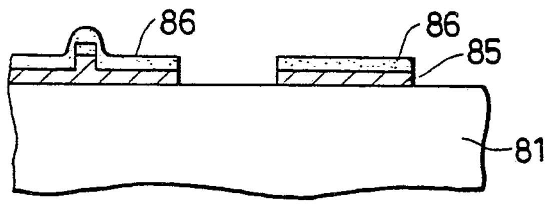


FIG. 5(e)

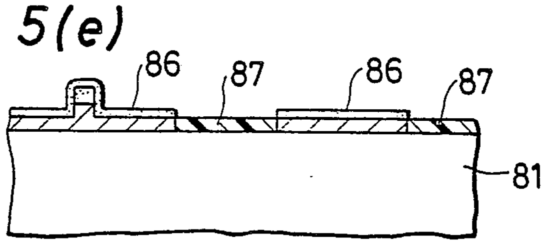

FIG. 5(f)

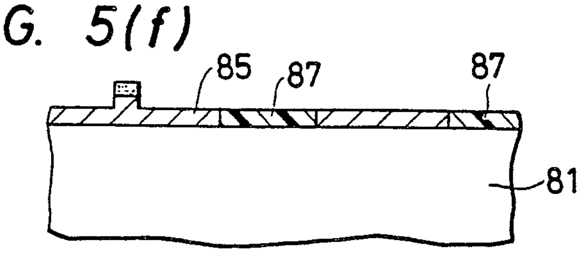


FIG. 5(g)

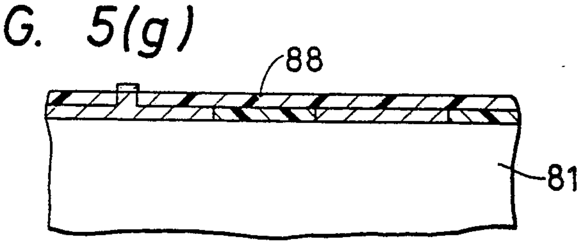


FIG. 5(h)

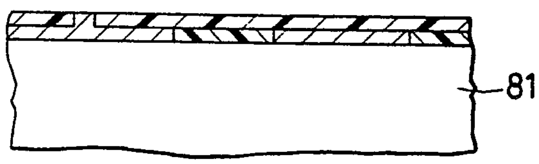


FIG. 5(i)